(19) Europäisches Patentamt
European Patent Office
Office européen des brevets

(11) **EP 1 970 974 A1**

(12) **EUROPEAN PATENT APPLICATION**

(43) Date of publication:
**17.09.2008 Bulletin 2008/38**

(51) Int Cl.:
***H01L 35/32*** *(2006.01)*

(21) Application number: **07020825.1**

(22) Date of filing: **24.10.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **15.03.2007 PCT/JP2007/055259**

(71) Applicant: **IBIDEN CO., LTD.**
**Ogaki-shi**
**Gifu 503-8604 (JP)**

(72) Inventor: **Ohno, Kazushige**
**Ibi-gun**
**Gifu 501-0965 (JP)**

(74) Representative: **HOFFMANN EITLE**
**Patent- und Rechtsanwälte**
**Arabellastrasse 4**
**81925 München (DE)**

(54) **Thermoelectric converter and method of manufacturing thermoelectric converter**

(57) A thermoelectric converter is disclosed, wherein p-type semiconductors (3) and n-type semiconductors (4) are alternately provided in corresponding first and second through holes, respectively, in a ceramic honeycomb (2), the first and second through holes having different cross-sectional shapes and being alternately arranged, and the semiconductors (3, 4) have their respective first and second ends successively connected to different ones of the semiconductors (3, 4) on the first and second sides, respectively, of the corresponding through holes.

FIG.1

**Description**

<u>BACKGROUND OF THE INVENTION</u>

1. Field of the Invention

The present invention relates to a thermoelectric converter using the Seebeck effect and a method of manufacturing the thermoelectric converter.

2. Description of the Related Art

When one end of a p-type semiconductor and one end of an n-type semiconductor are joined through an electrode, and this junction is set at high temperature while the other end of each of the p-type semiconductor and the n-type semiconductor is set at low temperature, an electromotive force is generated between the ends of each of the p-type semiconductor and the n-type semiconductor in accordance with the difference in temperature between the high temperature part and the low temperature part. The electromotive force generated between the ends of each of the p-type semiconductor and the n-type semiconductor is referred to as a thermoelectromotive force, and such an effect is referred to as the Seebeck effect. On the other hand, when one end of a p-type semiconductor and one end of an n-type semiconductor are joined through an electrode, and a current is caused to flow from the other ends of the p-type semiconductor and the n-type semiconductor, a difference in temperature is caused between the ends of each semiconductor. This phenomenon is referred to as the Peltier effect. Elements having these effects are collectively referred to as thermoelectric conversion elements. With respect to the Seebeck effect, the direction of current is reversed by switching the junction of the thermoelectric conversion element between high temperature and low temperature. Further, it is known that a greater electromotive force is obtained with a greater difference in temperature.

The electromotive force of each single thermoelectric conversion element is not so great. However, a thermoelectric conversion module into which a large number of such thermoelectric conversion elements are combined is a static thermoelectric converter characterized by no movable parts to cause vibration, noise, wear, etc., simple structure and high reliability, and a long service life and easy maintenance. Such a thermoelectric conversion module has two or more, usually several tens or more, thermoelectric conversion elements. The individual thermoelectric conversion elements are electrically joined in series, and are thermally arranged in parallel. The thermoelectric conversion module having such a configuration is used as a thermoelectric power generator using the Seebeck effect, extracting an electromotive force by depending on the difference between temperatures set at both ends of a thermoelectric conversion element, or as a thermoelectric temperature controller using the Peltier effect, cooling or heating one end of the thermoelectric conversion module by causing a difference in temperature by depending on the voltage applied across the thermoelectric conversion module.

Thermoelectric conversion materials can directly convert heat into electricity by the Seebeck effect or, conversely, can use electricity for heat (heating/cooling) by the Peltier effect. Thermoelectric conversion materials may be conventionally known materials for thermocouples for temperature measurement, for example, alloy or metal-alloy combinations such as Alumel/Chromel and platinum/platinum-rhodium. However, in the case where it is necessary to generate a large electromotive force or high thermal output with a small-size one, a combination of a p-type semiconductor and an n-type semiconductor is used. Thermoelectric conversion modules using semiconductors have the advantages of being able to control temperature with precision, being able to perform local cooling, being silent, being subject to no flon regulation (CFC controls), having a long service life and high reliability, and requiring no maintenance, and have been used for controlling the temperature of laser diodes for optical communications. They have also been considered for use as air conditioners as described in Patent Document 10 mentioned below.

On the other hand, in recent years, it has been required to substantially reduce $CO_2$ emission as a measure against global warming. It greatly contributes to energy savings and $CO_2$ reduction to make effective use of unused thermal energy in industrial, household, and transportational fields. Accordingly, thermal power generation modules capable of directly converting thermal energy into electric energy have been developed. For example, automobile engines utilize only a little less than 30% of energy on combustion as power, and discharge most of the rest of the energy together with exhaust gas. If an efficient thermoelectric converter is developed in such a field, it can be expected to substantially save energy and reduce $CO_2$ emission. Thermoelectric converters for automobiles are required to not only be small and lightweight but also have strength, resistance to vibration, flexibility in shape, durability, a wide range of operating temperatures, freedom from maintenance, a low impact on the environment, and the like. In particular, resistance to vibration and flexibility in shape are performance requirements different from those for other fields' purposes.

Here, a description is given of a conventional thermoelectric conversion module into which multiple thermoelectric conversion elements are combined. It is assumed that multiple p-type semiconductors and multiple n-type semiconductors having electrodes on the upper and lower sides are alternately arranged horizontally. A first p-type semiconductor and a first n-type semiconductor adjacent thereto are coupled with an upper electrode, and the first n-type semiconductor and a second p-type semiconductor adjacent thereto are coupled with a lower electrode on the side opposite to the upper electrode. In this manner, the first p-type semiconductor and the first n-type semiconductor are coupled on the upper side, the first n-type semiconductor and the second p-type semiconductor are coupled on the lower side, and then the second p-type semiconductor and a second n-type semiconductor adjacent thereto are connected on the upper side. Thus, the upper and lower electrodes do not join the same semiconductors, but join the semiconductors so that the semiconductors are successively connected in series so as to cause current to flow in the direction from the upper side of the first p-type semiconductor to the lower side of the second n-type semiconductor.

In this case, the first p-type semiconductor and the first n-type semiconductor are coupled through the upper electrode to form a thermoelectric conversion element, while on the lower side, the first n-type semiconductor and the second p-type semiconductor are coupled through the lower electrode to form another thermoelectric conversion element. That is, the p-type semiconductors and the n-type semiconductors are alternately coupled in series through electrodes. If a difference in temperature is caused between both sides (upper and lower sides) of this thermoelectric conversion module, a predetermined electromotive force is generated across the thermoelectric conversion module based on the performance of each thermoelectric conversion element, the number of thermoelectric conversion elements coupled, and the difference in temperature between both ends of the thermoelectric conversion module.

Known semiconductors for thermoelectric conversion elements include semiconductors of the Bi-Te system, Se-Te system, Cs-Bi-Te system, Pb-Te system, Pb-Se-Te system, Zn-Sb system, Co-Sb system, Ce-Fe-Co-Sb system, Si-Ge system, and the like. For example, a Bi-Te system thermoelectric material discovered by Goldsmid of the General Electric Company of the United States in 1954 is generally known as a thermoelectric material used in a low temperature range of normal temperature to approximately 200 °C. In general, many thermoelectric materials have a narrow range of application temperatures. Therefore, in the case of a Bi-Te system thermoelectric conversion material, a single-layer module is sufficient in a low temperature range not exceeding 200 °C. On the other hand, studies for obtaining a highly efficient thermal power generation module by combining thermoelectric materials having different ranges of application temperatures into two to three layers have been made for a middle to high temperature range exceeding 200 °C. Further, materials that perform with excellent characteristics in a middle to high temperature range have been developed. One of them is a $Zn_4Sb_3$ material, which is a p-type semiconductor thermoelectric material exhibiting high thermoelectric conversion performance in a middle temperature range of 200 to 400 °C. On the other hand, CoSb-based thermoelectric conversion materials can be p-type and n-type semiconductors that perform well in a middle to high temperature range of 300 to 700 °C.

However, many of these semiconductors contain harmful metal, so that attention is required in both their manufacture and use. Recently, metal-oxide-based semiconductors have drawn attention as thermoelectric conversion element materials that are likely to clear environmental issues. For example, semiconductor thermoelectric element materials of the $InO_2$-$SnO_2$ system, $(Ca, Bi)MnO_3$ system, $(Zn, Al)O$ system, $Na(Co, Cu)O_4$ system, $NaCo_2O_4$ system, and the like have been developed for practical use.

Generally, the thermoelectric conversion module is formed of several tens or more, sometimes several hundreds or more minute semiconductor elements, which are spaced from each other to form a skeleton structure. However, it is accompanied by manufacturing complexity to accurately arrange minute semiconductor elements in accordance with a desired arrangement pattern and form electrodes at both ends. Further, there is also a problem in that a completed module is mechanically weak. Several reports have been made of structures or manufacturing methods of a thermoelectric conversion module for solving these problems.

For example, there are a thermoelectric conversion module having p-type semiconductor elements and n-type semiconductor elements placed in a heat-resistant porous insulator (Patent Document 1) and a thermoelectric conversion module having p-type and n-type semiconductor elements housed in a molded substrate in which element housing holes are formed (Patent Document 2). Thermoelectric conversion modules of such configurations, where p-type and n-type semiconductor elements are provided in an insulator with through holes formed therein without using a jig for providing the semiconductor elements, are characterized by improved assembling operability, better insulation between elements, and increased mechanical strength.

Further, there have been proposed thermoelectric conversion modules where the gap between semiconductor elements is filled with an insulating material. Specifically, there are a thermoelectric conversion module where one or more pairs of a p-type semiconductor element and an n-type semiconductor element provided in a desired arrangement are embedded in an insulating material (Patent Document 3) and a thermoelectric conversion module where multiple p-type semiconductor layers and n-type semiconductor layers are stacked and air gaps are formed therein except for p-n junction parts so as to be filled with a vitreous substance (Patent Document 4).

Further, there is a thermoelectric conversion module having semiconductor thermoelectric elements inserted into an insulating honeycomb structure through an alkali-metal-silicate-based inorganic adhesive agent or an insulating filler formed of sol-gel glass (Patent Document 5). Further, there is a highly reliable thermoelectric conversion module obtained by using a cordierite frame as a frame for a thermoelectric conversion module and controlling thermal conductivity by controlling the porosity of cordierite (Patent Document 6). These thermoelectric conversion modules, which have the air gap between semiconductor elements filled with an insulating material, are characterized by increased mechanical strength and by improved oxidation resistance and corrosion resistance of semiconductor elements.

Others known as frames of thermoelectric conversion modules include low-melting glass of $B_2O_3$-PbO molded and used as a frame as described in Patent Document 7, calcium silicate mechanically processed and used as a frame as described in Patent Document 8, and silica glass formed into a lattice shape as described in Patent Document 9.

On the other hand, metal materials such as Al and Cu are used as electrode materials for thermoelectric conversion modules. These electrode materials are joined to thermoelectric conversion elements by a method such as thermal spraying or brazing and soldering. In particular, in the case of forming electrodes by thermal spraying, it is necessary to perform thermal spraying after inserting thermoelectric conversion elements into a frame material. This is because if there is no frame, a p-type semiconductor element and an n-type semiconductor element cannot be joined or a thermal spraying material adheres to a side of a thermoelectric conversion element to electrically and thermally connect the upper and lower surfaces of the thermoelectric conversion element, thereby degrading the power generation characteristic.

Patent Document 10 discloses a thermoelectric converter in which p-type semiconductors and n-type semiconductors having different cross-sectional areas are alternately arranged. This thermoelectric converter is not for power generation but is an air conditioner for heat generation or heat absorption. The cross-sectional areas of the p-type and n-type semiconductors are optimized in order to equalize their thermal resistances and electrical resistances between the higher temperature side and the lower temperature side. Further, the air conditioner disclosed therein has the p-type and n-type semiconductors isolated from each other by a very thin (described as a few $\mu$m) insulating layer.

[Patent Document 1] Japanese Laid-Open Patent Application No. 5-283753
[Patent Document 2] Japanese Laid-Open Patent Application No. 7-162039
[Patent Document 3] Japanese Laid-Open Patent Application No. 8-18109
[Patent Document 4] Japanese Laid-Open Patent Application No. 61-263176
[Patent Document 5] Japanese Laid-Open Patent Application No. 10-321921
[Patent Document 6] Japanese Laid-Open Patent Application No. 2005-129765
[Patent Document 7] Japanese Laid-Open Patent Application No. 8-153899
[Patent Document 8] Japanese Laid-Open Patent Application No. 11-340526
[Patent Document 9] Japanese Laid-Open Patent Application No. 2003-234516
[Patent Document 10] Japanese Laid-Open Patent Application No. 2000-286462

Various kinds of thermoelectric converters have been reported as described above, and a thermoelectric converter having oxide-based semiconductors housed in a frame of a ceramic material is a possible thermoelectric converter for power recovery usable in a range of normal temperature to approximately 1000 °C, resistant to vibration, having a certain level of strength, having little effect on the environment, and easily manufacturable as an in-vehicle thermoelectric converter. There have been reports on individual element technologies such as semiconductors as thermoelectric conversion elements, a frame for placing multiple thermoelectric conversion elements, and electrodes to connect thermoelectric conversion elements. However, no thermoelectric converters have heat utilization efficiency that enables practical power recovery while being balanced in performance wholly as an apparatus. In order to improve thermoelectric converters in heat utilization efficiency, it is important to maintain a balance between the electromotive forces of p-type and n-type semiconductor materials, not to mention increasing their electromotive forces. However, no reports have been made of thermoelectric converters manufactured from such viewpoints.

## SUMMARY OF THE INVENTION

According to one aspect of the present invention, there are provided a thermoelectric converter practical and highly efficient in heat utilization and a method of manufacturing a thermoelectric converter highly efficient in heat utilization.

According to one aspect of the present invention, there is provided a thermoelectric converter, characterized in that p-type semiconductors and n-type semiconductors are alternately provided in corresponding first and second through holes, respectively, in a ceramic honeycomb, the first and second through holes having different cross-sectional shapes and being alternately arranged, and the semiconductors have respective first and second ends thereof successively connected to different ones of the semiconductors on first and second sides, respectively, of the corresponding through holes.

According to one aspect of the present invention, there is provided a method of manufacturing a thermoelectric converter, characterized by the steps of forming a ceramic honeycomb in which first and second through holes having different cross-sectional shapes are alternately arranged; providing p-type semiconductors and n-type semiconductors alternately in the corresponding first and second through holes, respectively; and successively connecting respective first and second ends of the semiconductors to different ones of the semiconductors on first and second sides, respectively, of the corresponding through holes.

According to the present invention, it is possible to provide a practical thermoelectric converter having high heat utilization efficiency and a method of manufacturing a thermoelectric converter having high heat utilization efficiency.

BRIEF DESCRIPTION OF THE DRAWINGS

Other objects, features and advantages of the present invention will become more apparent from the following detailed description when read in conjunction with the accompanying drawings, in which:

FIG. 1 is a plan view of a thermoelectric converter according to the present invention;
FIG. 2 is a cross-sectional view of thermoelectric conversion elements;
FIG. 3 is a plan view of part of the thermoelectric converter according to the present invention;
FIG. 4 is a plan view of part of another thermoelectric converter according to the present invention; and
FIG. 5 is a diagram for illustrating attachment of an in-vehicle thermoelectric converter.

DETAILED DESCRIPTION OF THE PREFERRED EMBODIMENTS

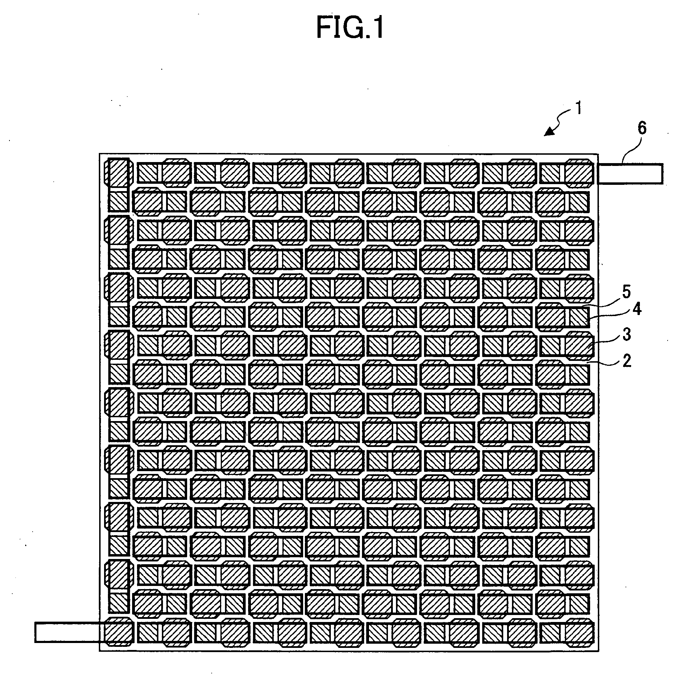

According to a thermoelectric converter of the present invention, two kinds of through holes having different cross-sectional shapes are alternately arranged in a ceramic honeycomb, and p-type semiconductors and n-type semiconductors are alternately provided in the corresponding through holes so as to have their respective ends successively connected to different semiconductors on the corresponding sides of the corresponding through hole. FIG. 1 is a plan view of a thermoelectric converter 1 according to one embodiment of the present invention. The thermoelectric converter 1 of this embodiment has p-type semiconductors 3 and n-type semiconductors 4 alternately placed in corresponding through holes of a ceramic honeycomb 2. (Each through hole of a honeycomb is also referred to as a cell.) The p-type semiconductors 3 and the corresponding n-type semiconductors 4 are coupled through electrodes 5 to form respective thermoelectric conversion elements. In the honeycomb 2, the p-type semiconductors 3 are placed in octagonal cells having cross-sectional shapes approximate to a square, and the n-type semiconductors 4 are placed in square cells. According to the thermoelectric converter 1 of this embodiment, the honeycomb 2 has 289 (17 x 17) cells. Further, 144 (horizontally 8.5 x vertically 17 = 144.5) thermoelectric conversion elements are placed. Usually, the thermoelectric converter of the present invention is formed by placing several tens to several hundreds of such thermoelectric conversion elements into which the p-type semiconductors 3 and the n-type semiconductors 4 are combined. In FIG. 1, reference numeral 6 denotes terminals.

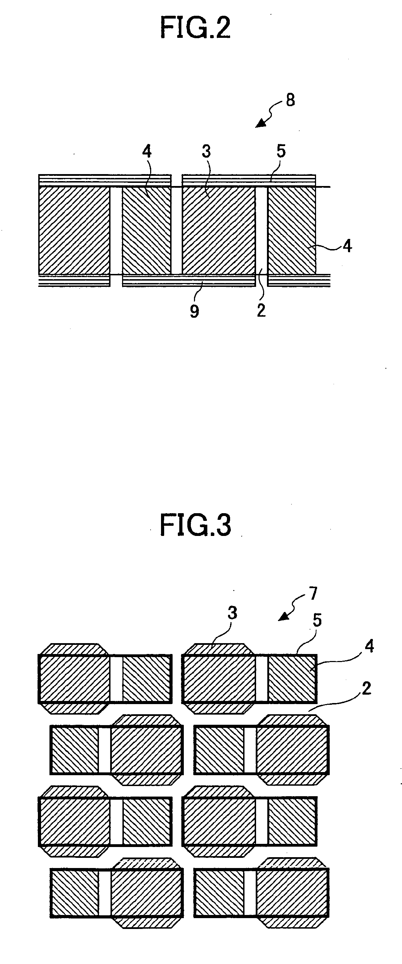

According to the thermoelectric converter 1 of the present invention, the ceramic honeycomb 2 is used as a frame so that the thermoelectric conversion elements can resist a temperature as high as approximately 1000 °C on the higher temperature side. The p-type semiconductors 3 and the n-type semiconductors 4 are placed in the corresponding through holes of the honeycomb 2. The ends of the adjacent p-type and n-type semiconductors 3 and 4 are electrically coupled so as to be connected in series or parallel. Accordingly, each semiconductor element is connected to corresponding ends of different semiconductor elements at the higher-temperature-side end and at the lower-temperature-side end. FIG. 2 is a cross-sectional view of two connected thermoelectric conversion elements. The p-type semiconductor 3 between the n-type semiconductors 4 is coupled to one of the n-type semiconductors 4 via the upper electrode 5 and is coupled to the other one of the n-type semiconductors 4 via a lower electrode 9 on the other side. The electrodes 5 and 9 do not couple the same semiconductors, but successively couple the p-type and n-type semiconductors 3 and 4 in series so that, for example, the p-type semiconductor 3 on the furthest left in FIG. 2 is coupled to the adjacent n-type semiconductor 4 on the upper side, the n-type semiconductor 4 is then coupled to the other p-type semiconductor 3 on the lower side, and the p-type semiconductor 3 is connected to the other n-type semiconductor 4 on the upper side, so that current flows from the upper left to the lower right through the p-type and n-type semiconductors 3 and 4 in FIG. 2. That is, as shown in the cross-sectional view of thermoelectric conversion elements of FIG. 2, the ends of the p-type semiconductor 3 are alternately connected to corresponding ends of the n-type semiconductors 4 through the higher-temperature-side electrode 5 and the lower-temperature-side electrode 9. The ends of the p-type and n-type semiconductors 3 and 4 are connected in series in the case shown in FIG. 2, but may also be connected in parallel.

FIG. 3 is a plan view of a thermoelectric conversion module into which eight thermoelectric conversion elements are combined in the above-described manner. In FIG. 3, for example, the p-type semiconductor 3 and the n-type semiconductor 4 are connected via the electrode 5 so as to form one thermoelectric conversion element. On the other side of the thermoelectric conversion element (the lower side, not shown in the drawing), the p-type semiconductor 3 and the n-type semiconductor 4 of adjacent thermoelectric conversion elements are coupled via the electrode 9 (not shown in the drawing) to form one thermoelectric conversion element. That is, the p-type semiconductors 3 and the n-type semiconductors 4 are alternately connected in series via the electrodes 5 and 9. If a difference in temperature is caused between both sides (upper and lower sides in FIG. 2) of this thermoelectric conversion module, a predetermined electromotive force is generated across the thermoelectric conversion module based on the performance of each thermoelectric conversion element, the number of thermoelectric conversion elements coupled, and the difference in temperature between both ends of the thermoelectric conversion module.

According to the thermoelectric converter 1 of the present invention, there are two kinds of cross-sectional shapes of cells. The p-type semiconductors 3 are placed in cells of one shape, and the n-type semiconductors 4 are placed in cells of the other shape. The cross-sectional shapes of cells may be any shapes such as square, rectangular, equilaterally hexagonal, octagonal, and circular shapes. Further, the cross-sectional shapes of cells may be two kinds of similar shapes having different cross-sectional areas. In other words, according to the thermoelectric converter 1 of the present invention, the p-type semiconductors 3 and the n-type semiconductors 4 have respective different predetermined cross-sectional areas.

In practical use, it is preferable that the combination of two kinds of cross-sectional shapes of cells be suitable for manufacture of a ceramic honeycomb and that the partition wall between cells, which is a part other than the part having semiconductors placed therein and functioning effectively, be small in proportion. On the other hand, the partition wall cannot have an extremely thin part considering the strength of the honeycomb and the electrical insulation between cells. In order to satisfy these conditions, it is desirable that the partition wall be substantially uniform in thickness.

As honeycombs having the same cross-sectional shape, those having a square or equilaterally hexagonal cell structure are known. These honeycombs have regularly arranged cells divided by a partition wall of the same thickness. In this case, however, the partition wall between cells should be non-uniform in thickness in order to make a honeycomb where cells of two kinds of cross-sectional shapes (cross-sectional areas) having any cross-sectional areas are alternately arranged. If the partition wall between cells is non-uniform in thickness, as a whole, the part of the partition wall increases in proportion while the part of the cells, which are through holes, is reduced in proportion. That is, the part where semiconductor elements can be placed is reduced in proportion, so that the part that can be effectively used as a thermoelectric converter is reduced.

On the other hand, according to the thermoelectric converter of the present invention, the partition wall in the honeycomb structure can be provided with a uniform thickness necessary and as small as possible in terms of strength, insulation, and the like and two kinds of cells of a desired cross-sectional area ratio can be combined. Therefore, it is possible to freely determine the ratio of the cross-sectional area of p-type semiconductors to the cross-sectional area of n-type semiconductors while making the most of the cross section of the honeycomb as a thermoelectric conversion region.

For example, by combining square cells and octagonal cells, shaped like squares larger than the square cells with their four corners cut off, as shown in FIG. 3, the partition wall between cells can be constant in thickness, and the proportion of through holes in the honeycomb can be increased. Further, providing the structure of the honeycomb with such a shape makes it possible to arbitrarily change the ratio of the area of the squares to the area of the octagons, thus being suitable as a specific combination of two kinds of cells.

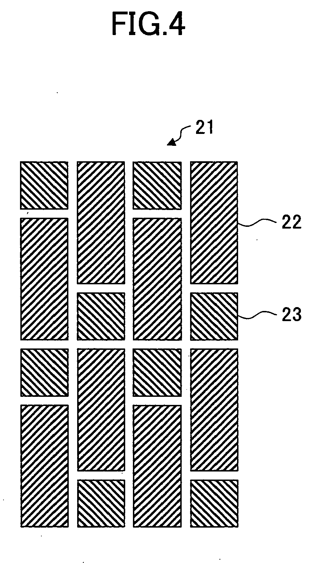

Suitable specific combinations of two kinds of cells according to the present invention may include a combination of squares and rectangles as shown in FIG. 4. FIG. 4 is a plan view of part of another thermoelectric converter 21 according to the present invention. In this case, the short sides of a rectangle 22 have the same length as the sides of a square 23. Such a honeycomb structure also makes it possible to arbitrarily change the area ratio of two kinds of cells and to keep the thickness of the partition walls between cells constant at the necessary minimum, thereby reducing the waste of the partition wall part that does not contribute to power generation. Thus, such a honeycomb structure is suitable as a specific combination of two kinds of cells according to the present invention.

A description is given of the action of the difference between the shapes of two kinds of cells, that is, the cross-sectional shapes of p-type and n-type semiconductors in the honeycomb of a thermoelectric converter of the present invention. Each of the p-type and n-type semiconductors has a thermoelectric conversion capability, and the output P of each semiconductor element is expressed as follows:

$$P = \{Z\kappa(\Delta T)^2/4\} \times (S/h), \qquad \cdots (1)$$

$$Z = \alpha^2\sigma/\kappa, \qquad \cdots (2)$$

where Z represents the figure of performance of the semiconductor element, $\kappa$ represents its thermal conductivity, $\Delta T$ represents the temperature difference between both sides of the semiconductor element, S represents the cross-sectional area of the semiconductor element, h represents the height (length) of the semiconductor element, $\alpha$ represents its electromotive force, and $\sigma$ represents its electrical conductivity.

Substituting Eq. (2) for Z in Eq. (1), P is expressed by the following Eq. (3):

$$P = \{\alpha^2\sigma(\Delta T)^2/4\} \times (S/h). \qquad \cdots (3)$$

As shown by Eq. (3), $\alpha^2\sigma$ is the property of the individual semiconductor material, $\Delta T$ is the temperature difference between both sides of a thermoelectric conversion element, and S and h are the cross-sectional area and height, respectively, of the individual semiconductor element. When this relationship is applied to the thermoelectric converter of the present invention, the p-type and n-type semiconductors have the same temperature difference between both sides of the semiconductor $\Delta T$ and the same height of the semiconductor h. Further, $\alpha^2\sigma$, which is the property of the individual semiconductor material, is determined when the p-type or n-type semiconductor is selected. The cross-sectional area of the semiconductor element S can be set to a predetermined value based on the two kinds of shapes of cells in manufacturing a honeycomb.

In this thermoelectric converter as thermoelectric conversion elements into which the p-type and n-type semiconductors are combined, the efficiency of power extraction is maximized when the electromotive force Pp of the p-type semiconductor is equalized with the electromotive force Pn of the n-type semiconductor. Accordingly, Pp can be equalized with Pn by adjusting the cross-sectional area of the semiconductor element S with respect to the value ($\alpha^2\sigma$) derived from the thermoelectromotive force and the electrical conductivity regarding each semiconductor. That is, the ratio of the cross-sectional area of the n-type semiconductor Sn to the cross-sectional area of the p-type semiconductor Sp may be adjusted so as to satisfy the following Eq. (4):

$$\{\text{p-type semiconductor coefficient } (\alpha^2\sigma)p\}/\{\text{n-type semiconductor coefficient } (\alpha^2\sigma)n\} = \{\text{n-type semiconductor cross-sectional area } Sn\}/\{\text{p-type semiconductor cross-sectional area } Sp\}. \qquad \cdots (4)$$

The other coefficients ($\Delta T$) and h, which are not values that differ from semiconductor element to semiconductor element, are not subjected to adjustment.

A description is given, with reference to FIGS. 2 and 3, of actions of the thermoelectric converter of the present invention. FIG. 2 is a cross-sectional view of part of thermoelectric conversion elements and FIG. 3 is a plan view of part of thermoelectric conversion elements provided in the thermoelectric converter 1 shown in FIG. 1.

Each of thermoelectric conversion elements 8 shown in FIG. 2 and thermoelectric conversion elements 7 shown in FIG. 3 has a temperature difference between its upper surface and lower surface (corresponding to the upper side and the lower side in FIG. 2) so as to generate an electromotive force. For example, power can be generated with a temperature difference of approximately 300 °C by bringing the upper surface into contact with a metal plate or an atmosphere of a good heat transfer characteristic heated to 350 °C and cooling the lower surface to 30 to 50 °C. These individual thermoelectric conversion elements can be made into a single power generator as a whole by joining their respective ends in series with electrodes like battery (electric cells). At this point, by providing the cross-sectional areas of the cells formed in a ceramic honeycomb as described above with the relationship shown in the above-described Eq. (4), the thermoelectric converter of the present invention can perform thermoelectric conversion most efficiently.

In general, a large number of thermoelectric conversion elements are required to generate a large electromotive force in a thermoelectric converter. On the other hand, as can be seen from the above-described Eq. (3), the length of a thermoelectric conversion element in the directions of the temperature difference, that is, the thickness of the thermoelectric converter, is required to be as small as possible in order to cause the thermoelectric conversion element to efficiently generate an electromotive force. In order to satisfy both of these requirements, a large-area, thin-plate-like thermoelectric converter is required. However, such a shape is subject to great change due to thermal expansion so that breakage is likely to occur. Further, the thermoelectric converter is also likely to break because of a bending stress or the like unless the thermoelectric converter is formed of a material having very high rigidity or flexibility. Therefore, according to the present invention, it is preferable to manufacture a thermoelectric converter that causes a desired electromotive force to be generated by connecting multiple thermoelectric conversion modules that serve as units of thermoelectric conversion and are smaller than or equal to a predetermined size. Each thermoelectric conversion module may have a predetermined size in accordance with a purpose. If the thermoelectric conversion module is smaller than or equal to a predetermined size, thermal distortion due to the difference between the thermal expansions of both sides of the thermoelectric conversion module is small, so that the thermoelectric conversion module is less likely to break even with thermal impact, mechanical impact, or vibrations. Further, strength is sufficient even with a ceramic, which is a brittle material, used as a frame. Further, a ceramic, which has heat resistance and electrical insulation, is convenient as a frame.

With respect to a specific size of this thermoelectric conversion module, the maximum length in a cross section perpendicular to a through hole of the honeycomb is preferably less than or equal to 100 mm, and more preferably less than or equal to 50 mm in particular. The maximum length of the cross section is the length of a side in the case of a square or a rectangle, the distance between opposing sides in the case of a hexagon or an octagon, or a diameter in the case of a circular shape. Usually, the shape of the cross section perpendicular to the through hole of the honeycomb is preferably a square or a rectangle or octagon approximate to a square in terms of the strength and the placement efficiency of the thermoelectric conversion module. The lower limit of the maximum length of the above-described cross section is not limited in particular, but is preferably more than or equal to 5 mm, more preferably more than or equal to 10 mm, and still more preferably more than or equal to 20 mm considering the size of a semiconductor element and the number of cells of the ceramic honeycomb. In general, a ceramic honeycomb structure of 0.7 to 2.0 mm in thickness is more likely to sustain brittle fracture in response to a bending stress if the maximum length of the above-described cross section is more than or equal to 50 mm, in particular more than or equal to 100 mm. Further, the weight increases in proportion to the size, so that a stress is likely to be applied in response to impact so as to increase the risk of breakage.

If the width of each cell is determined to be 0.8 mm and the partition wall between cells is determined to be 0.2 mm in thickness based on the above-described honeycomb 10 cm square in size, the number of cells formable is 10,000 (100 × 100), and the number of cells is preferably smaller than this. Usually, it is preferable that the number of cells be 100 to 2000.

The honeycomb for the thermoelectric converter or the thermoelectric conversion module according to the present invention is made of a ceramic. Ceramic materials may be any materials having insulation and heat resistance, such as oxide ceramics, silicon nitride, aluminum nitride, silicon carbide, and composite materials formed of these ceramics or containing these ceramics. Of these ceramic materials, oxide ceramics are particularly preferable. Oxide ceramics are suitable materials in terms of heat resistance, insulation, strength, thermal conductivity, thermal expansibility, and the like. Thermal conductivity and thermal expansibility are preferably close to those of a below-described semiconductor material that is a thermoelectric element material rather than particularly high or low. If the value of thermal expansibility of the honeycomb material is close to that of the thermoelectric element material, temperature is likely to be uniform in the internal cross section parallel to the surface of a thermoelectric conversion module when they are put in an environment of a great temperature difference as the thermoelectric conversion module, so that it is possible to reduce distortion due to thermal expansion. Preferable oxide ceramics include alumina, silica, magnesia, mullite, cordierite, aluminum titanate, titania, ceria, and the like. Of these, alumina and cordierite are particularly suitable honeycomb materials.

Semiconductor materials for thermoelectric conversion elements in the thermoelectric converter of the present invention may be any materials as long as they have a thermoelectric conversion function. The thermoelectric conversion function of a semiconductor material is as follows. Since a p-type semiconductor and an n-type semiconductor generate electromotive forces of opposite polarities with the same temperature difference, by connecting the end of the p-type semiconductor and the end of the n-type semiconductor through an electrode on one side of the thermoelectric conversion module, an electromotive force that is the sum of the electromotive force of the p-type semiconductor and the electromotive force of the n-type semiconductor is obtained between the end of the p-type semiconductor and the end of the n-type semiconductor on the opposite side. Usually, these terminals on the opposite side are coupled to the terminals of corresponding adjacent thermoelectric conversion elements so as to increase the electromotive force. At this point, series coupling and parallel coupling are possible as methods of coupling adjacent thermoelectric elements. Thinking about only a theoretical electromotive force, the same electromotive force is obtained by either method, and the difference lies between collecting in high-voltage, small-current power and collecting in low-voltage, large-current power. Practically, however, internal resistance is generated in the semiconductor material when a current flows therethrough because the semiconductor material is not a conductor. In order to reduce its effect, it is preferable to reduce current flowing inside the semiconductor. For this purpose, it is preferable that the individual thermoelectric conversion elements in the thermoelectric conversion module be coupled in series. Thereby, a high-voltage, small-current electromotive force is generated.

Specific semiconductor materials of p-type and n-type semiconductors include materials of the Bi-Te system, Se-Te system, Cs-Bi-Te system, Pb-Te system, Pb-Se-Te system, Zn-Sb system, Co-Sb system, Ce-Fe-Co-Sb system, Si-Ge system, and the like. More preferable semiconductor materials include materials of the $InO_2$-$SnO_2$ system, (Ca, Bi)$MnO_3$ system, (Zn, Al)O system, Na(Co, Cu)$O_4$ system, $NaCo_2O_4$ system, and the like. Particularly preferable combinations of p-type and n-type semiconductors include a combination of $NaCoO_2$ and ZnO, a combination of $NaCoO_2$ and (Ca$_{0.9}$Bi$_{0.1}$)$MnO_3$, a combination of $Ca_3Co_4O_9$ and ZnO, a combination of $Ca_3Co_4O_9$ and (Ca$_{0.9}$Bi$_{0.1}$)$MnO_3$, and the like. Here, semiconductor materials are shown as Bi-Te system, ZnO, etc., which are all semiconductors, p-type or n-type semiconductors formed by doping with other elements, and are not limited to pure metals or metal compounds. For example, ZnO may be an n-type semiconductor formed by doping with A1.

In a thermoelectric converter formed by connecting multiple thermoelectric conversion modules, it is preferable that the thermoelectric conversion modules be connected to each other in a movable manner. In particular, a high-performance thermoelectric conversion module is preferably shaped like a thin plate. Therefore, if these thermoelectric conversion modules are tightly fixed and connected so as not to be movable relative to each other, this results in the same condition as a single large thermoelectric converter. If the thermoelectric conversion modules are arranged on a substrate having sufficient strength and rigidity, by tightly fixing the thermoelectric conversion modules, it is possible to cause the substrate to absorb all external stress so as to prevent the stress from affecting the thermoelectric conversion modules. For this, however, the substrate should be examined in many functions for adaptation to the thermoelectric conversion modules, such as strength, rigidity, heat resistance, thermal expansibility, heat transferability, and insulation. Therefore, if the thermoelectric conversion modules are coupled so as to be movable relative to each other, each thermoelectric conversion module moves relatively to relieve a stress even if a mechanical stress or a stress due to the effect of heat is applied to the thermoelectric converter. Alternatively, a coupling member that couples the thermoelectric conversion modules in a movable manner absorbs the stress, so that a flow stress is less easily applicable to the thermoelectric conversion modules.

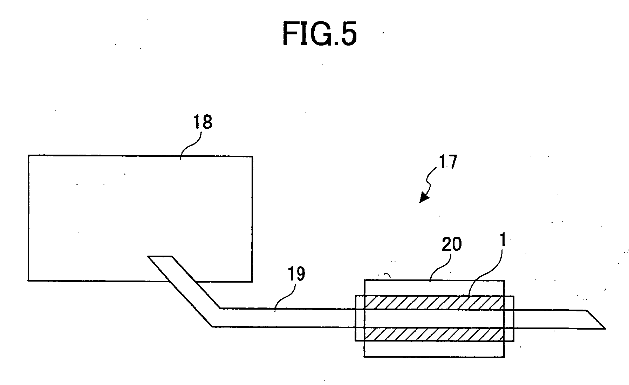

The thermoelectric converter having thermoelectric conversion modules connected to each other in a movable manner is also effective in handling and installation in a desired part. For example, it is possible to place the thermoelectric converter while deforming it in accordance with the shape of an installation location. In the case of installing the thermoelectric converter in the exhaust pipe of an automobile engine as shown in FIG. 5, the thermoelectric converter may be formed into a cylindrical shape.

The thermoelectric conversion modules may be connected to each other in a movable manner by, for example, arranging the thermoelectric conversion modules on a flexible substrate. The substrate and the thermoelectric conversion modules may be connected by any method, for example, bolting, fixation with hooks projecting from the substrate, or bonding with an adhesive agent. The materials of the substrate and a joining jig and the joining method are selected in view of the environment in which the thermoelectric conversion modules are to be used. For example, in the case of placing the substrate on the higher temperature side of the thermoelectric conversion modules, it is preferable to select a metal material that resists the service temperature of the substrate. In the case of placing the substrate on the lower temperature side of the thermoelectric conversion modules, it is also possible to select a plastic or rubber material that resists the service temperature of the substrate. Further, the substrate may not be used as a connection method, and the thermoelectric conversion modules may be connected with flexible tapes or string-like connecting members. Alternatively, the thermoelectric conversion modules may be coupled with a flexible adhesive agent. Further, it is also possible to use leads or connecting terminals for electrically connecting the thermoelectric conversion modules as flexible connection members.

A description is given of a method of manufacturing a thermoelectric converter according to the present invention, taking cordierite as an example of a ceramic honeycomb. Cordierite material powder includes Al, Si, and Mg oxides as main components, and contains 10-30% Al in terms of $Al_2O_3$, 40-60% Si in terms of $SiO_2$, and 10-30% Mg in terms of MgO when Al, Si, and Mg are converted into $Al_2O_3$, $SiO_2$, and MgO, respectively, to be 100 at% in total. Further, those in which CaO is 0-0.05%, $Na_2O$ is 0-0.05%, $K_2O$ is 0-0.05%, $TiO_2$ is 0-1%, $Fe_2O_3$ is 0-1%, PbO 0-1%, and/or $P_2O_5$ is 0-0.2% are selectable. The inevitably mixed components such as CaO, $Na_2O$, $K_2O$, $TiO_2$, $Fe_2O_3$, PbO, and $P_2O_5$ are preferably less than or equal to 2.5% in total. Most of the frame after firing contains cordierite as a main component, but in some cases, the frame contains mullite, spinel, or the like.

The above-described material is input into a medium such as water or alcohol together with a molding aid to be fully mixed and crushed into slurry. Then, a raw material body of pillar honeycomb structure is made by extrusion molding. This honeycomb structure may be the same size as a thermoelectric conversion module. Usually, however, it is convenient to make a honeycomb structure greater in both cross-sectional area and length than a thermoelectric conversion module and to use it by cutting it in the process of manufacturing thermoelectric conversion modules. Further, usually, the shape of each cell of the honeycomb structure may be a square, an equilateral hexagon, a circle, or a rectangle or octagon approximate to a square. Further, the ratio of the cross-sectional area of a p-type semiconductor to the cross-sectional area of an n-type semiconductor may be determined in accordance with the respective cross-sectional areas of the p-type and n-type semiconductors, predetermined from their respective capabilities, of a desired thermoelectric conversion module. For example, the ratio of the cross-sectional area of a p-type semiconductor to the cross-sectional area of an n-type semiconductor may be 1 : 3 to 3 : 1. This honeycomb structure is dried and degreased. The degreased honeycomb structure is cut into thin-plate-like honeycombs having a thickness corresponding to the thickness of thermoelectric conversion modules after firing. Alternatively, the cutting may be performed after insertion of semiconductor materials or after firing described below.

Predetermined semiconductor materials are inserted into corresponding cells of a plate-like honeycomb. The semiconductor materials may be in any form such as powder, slurry, or paste. In the case of slurry or paste, re-drying is performed to remove a solvent, and the plate-like honeycomb having the semiconductor materials inserted thereinto is subjected to firing, so that a cordierite honeycomb having a semiconductor inserted into each cell is obtained. Firing may be at 1200 to 1400 °C, the same as a usual cordierite firing condition. The surfaces of this cordierite honeycomb are polished so as to smooth the fired surfaces of the semiconductors and the fired surfaces of the cordierite honeycomb. If the cordierite honeycomb has a greater shape than a desired thermoelectric conversion module, thermoelectric conversion modules are cut out from the cordierite honeycomb. For example, if the cordierite honeycomb is three times a thermoelectric conversion module on each side, the cordierite honeycomb is equally divided into three both vertically and horizontally so as to manufacture nine honeycombs for thermoelectric conversion modules in total.

Electrodes are connected to the shaped honeycombs for thermoelectric conversion modules. The cross-sectional view of FIG. 2 shows the electrode structure of thermoelectric conversion elements. In the upper part of the drawing, which is the higher-temperature-side coupling of the thermoelectric conversion element, the p-type semiconductor 3 and the n-type semiconductor 4 are coupled with the higher-temperature-side copper electrode 5. At this point, the higher-temperature-side electrode 5 is adhered to the p-type semiconductor 3 and the n-type semiconductor 4 with a conductive adhesion member. This adhesion member not only improves the adhesion between the higher-temperature-side electrode 5 and the p-type and n-type electrodes 3 and 4, but also prevents diffusion of their respective atoms to each other. This is because the thermoelectric conversion performance may be degraded if atoms move into or from a semiconductor to be diffused. On the lower temperature side, the p-type semiconductor 3 and the n-type semiconductor 4 may be coupled with the lower-temperature-side copper electrode 9, which is a copper electrode like the higher-temperature-side electrode 5. With respect to the junction of the lower-temperature-side electrode 9, where temperature is low, there is no need to give much consideration to diffusion of atoms, so that there is much latitude of material choice. The electrodes may be connected by any method such as thermal spraying, transferring, coating, or bonding. Preferably, the surfaces of the thermoelectric conversion element including the higher-temperature-side electrode 5 and the lower-temperature-side electrode 9 are coated with an insulator so as to prevent generated power from leaking out.

The thermoelectric converter of the present invention can be suitably used as an in-vehicle one that utilizes automobile waste heat. For example, the thermoelectric converter of the present invention may be placed around the exhaust pipe of an automobile to generate power as shown in FIG. 5. In an in-vehicle thermoelectric converter 17 shown in FIG. 5, the higher temperature side of the thermoelectric converter 1 is placed on the side facing an exhaust pipe 19 connected to an engine 18, while a cooling unit 20 of, for example, a cooling water circulation or air cooling type is provided on the lower temperature side. The thermoelectric converter 1 has plate-like thermoelectric conversion modules of approximately 30 mm square and 1 mm in thickness fixed with a thin metal plate. Since the metal plate is flexible, the metal plate absorbs vibrations of the automobile and impact so as to prevent a great mechanical stress from being applied to the thermoelectric conversion modules. Further, since the thermoelectric conversion modules have a plate shape of approximately 30 mm square, thermal stress is prevented from becoming high as well.

The thermoelectric converter of the present invention, which can extract large-capacity power from heat sources of relatively low temperatures through high temperatures, approximately 1000 °C, can be used as a power generator. In particular, the thermoelectric converter of the present invention has high heat utilization efficiency, and can effectively extract electric power from automobile exhaust gas as an in-vehicle power generator, so as to be usable as a power source for motive power or auxiliary devices.

**Claims**

1. A thermoelectric converter, **characterized in that**:

    p-type semiconductors (3) and n-type semiconductors (4) are alternately provided in corresponding first and second through holes, respectively, in a ceramic honeycomb (2), the first and second through holes having different cross-sectional shapes and being alternately arranged, and
    the semiconductors (3, 4) have respective first and second ends thereof successively connected to different ones of the semiconductors (3, 4) on first and second sides, respectively, of the corresponding through holes.

2. The thermoelectric converter as claimed in claim 1, **characterized in that**:

the first through holes have a square cross-sectional shape and the second through holes have an octagonal cross-sectional shape.

3. The thermoelectric converter element as claimed in claim 1 or 2, **characterized in that**:

a cross-sectional area ratio of the first and second through holes is predetermined in accordance with a combination of the p-type and n-type semiconductors (3, 4).

4. A method of manufacturing a thermoelectric converter, **characterized by** the steps of:

forming a ceramic honeycomb (2) in which first and second through holes having different cross-sectional shapes are alternately arranged;
providing p-type semiconductors (3) and n-type semiconductors (4) alternately in the corresponding first and second through holes, respectively; and
successively connecting respective first and second ends of the semiconductors (3, 4) to different ones of the semiconductors (3, 4) on first and second sides, respectively, of the corresponding through holes.

# FIG.1

# FIG.2

# FIG.3

FIG.4

# FIG.5

**European Patent Office**

## EUROPEAN SEARCH REPORT

Application Number

EP 07 02 0825

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 5 952 728 A (IMANISHI YUICHIRO [JP] ET AL) 14 September 1999 (1999-09-14) * column 5, line 28 - column 8, line 9; figures 3-5 * | 1-4 | INV. H01L35/32 |
| Y | WO 99/50910 A (RAYTHEON CO [US]) 7 October 1999 (1999-10-07) * page 9, line 8 - line 19; figure 3 * | 1-4 | |
| Y | EP 1 030 379 A (NGK INSULATORS LTD [JP]) 23 August 2000 (2000-08-23) * figures 1-3 * | 1-4 | |
| Y | JP 11 135841 A (CITIZEN WATCH CO LTD) 21 May 1999 (1999-05-21) * figure 9 * | 1-4 | |
| A | GB 1 225 034 A (BORG WARNER [US]) 17 March 1971 (1971-03-17) * the whole document * | 1-4 | |
| A | US 2004/231714 A1 (STARK INGO [DE] ET AL) 25 November 2004 (2004-11-25) * paragraph [0033]; figure 3 * | 1-4 | TECHNICAL FIELDS SEARCHED (IPC) H01L |

The present search report has been drawn up for all claims

| Place of search | Date of completion of the search | Examiner |
|---|---|---|
| The Hague | 29 May 2008 | Kirkwood, Jonathan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 1 970 974 A1**

**ANNEX TO THE EUROPEAN SEARCH REPORT
ON EUROPEAN PATENT APPLICATION NO.**

EP 07 02 0825

This annex lists the patent family members relating to the patent documents cited in the above-mentioned European search report.
The members are as contained in the European Patent Office EDP file on
The European Patent Office is in no way liable for these particulars which are merely given for the purpose of information.

29-05-2008

| Patent document cited in search report | | Publication date | Patent family member(s) | | Publication date |
|---|---|---|---|---|---|
| US 5952728 | A | 14-09-1999 | DE | 19646915 A1 | 15-05-1997 |
| | | | FR | 2741196 A1 | 16-05-1997 |
| | | | GB | 2307338 A | 21-05-1997 |
| | | | JP | 9199765 A | 31-07-1997 |
| WO 9950910 | A | 07-10-1999 | AU | 3219699 A | 18-10-1999 |
| | | | DE | 69911390 D1 | 23-10-2003 |
| | | | EP | 1070350 A1 | 24-01-2001 |
| | | | JP | 2002510864 T | 09-04-2002 |
| | | | US | 6043982 A | 28-03-2000 |
| EP 1030379 | A | 23-08-2000 | DE | 60029855 T2 | 15-02-2007 |
| | | | JP | 2000236117 A | 29-08-2000 |
| | | | US | 6288322 B1 | 11-09-2001 |
| JP 11135841 | A | 21-05-1999 | NONE | | |
| GB 1225034 | A | 17-03-1971 | NONE | | |
| US 2004231714 | A1 | 25-11-2004 | AU | 2004241965 A1 | 02-12-2004 |
| | | | CA | 2526270 A1 | 02-12-2004 |
| | | | CN | 1836340 A | 20-09-2006 |
| | | | EP | 1625629 A1 | 15-02-2006 |
| | | | JP | 2007500951 T | 18-01-2007 |
| | | | MX | PA05012477 A | 03-07-2006 |
| | | | US | 2005252543 A1 | 17-11-2005 |
| | | | WO | 2004105143 A1 | 02-12-2004 |

EPO FORM P0459

For more details about this annex : see Official Journal of the European Patent Office, No. 12/82

17

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5283753 A
- JP 7162039 A
- JP 8018109 A
- JP 61263176 A
- JP 10321921 A
- JP 2005129765 A
- JP 8153899 A
- JP 11340526 A
- JP 2003234516 A
- JP 2000286462 A